# EUROPEAN PATENT APPLICATION

(11) **EP 4 421 874 A1**
(43) Date of publication of application: **28.08.2024**
(21) Application number: 24152507.0
(22) Date of filing: 18.01.2024
(51) Int. Cl.: H01L 29/06, H01L 29/16, H01L 21/329, H01L 29/87

(54) **HIGH PERFORMANCE SILICON CONTROLLED RECTIFIER DEVICES**

(30) Priority: 21.02.2023 US 202318111959
(71) Applicant: GlobalFoundries U.S. Inc., Malta, NY 12020 (US)
(72) Inventor: PANDEY, Shesh Mani, Saratoga Springs, NY, 12866 (US); KARALKAR, Sagar Premnath, 738406 Singapore (SG); KRISHNASAMY, Rajendran, Essex Junction, VT, 05452 (US); TAN, Chung Foong, Malta, NY, 12020 (US)
(74) Representative: Lambacher, Michael

(57) **Abstract**

The present disclosure relates to semiconductor structures and, more particularly, to high performance silicon controlled rectifier (SCR) devices and methods of manufacture. The structure includes: a first well in a semiconductor substrate; a second well in the semiconductor substrate, adjacent to the first well; and a porous semiconductor region extending in the first well and the second well.

## Description

### BACKGROUND

The present disclosure relates to semiconductor structures and, more particularly, to high performance silicon controlled rectifier (SCR) devices and methods of manufacture.

A silicon controlled rectifier (SCR) is a solid-state current-controlling device, which is a unidirectional device (i.e., can conduct current only in one direction). The SCR typically includes a switching configuration comprising p-n-p-n layers.

A holding current of an SCR can be defined as the smallest amount of current under which an anode current has to drop to enter an OFF status. This means if the holding current value is 5 mA, for example, subsequently the SCR's anodes' current has to turn into less than 5 mA to discontinue performing. A triggering voltage, on the other hand, may occur when the anode terminal is made +ve relating to the cathode in which case the SCR will be in a forwarding biased mode, e.g., enters into the forward blocking state. This means the device is switched from the blocked (OFF) state to the unblocked (ON) state.

### SUMMARY

In an aspect of the disclosure, a structure comprises: a first well in a semiconductor substrate; a second well in the semiconductor substrate, adjacent to the first well; and a porous semiconductor region extending in the first well and the second well.

Additional features of the structure are set forth in dependent claims 2 to 9.

In an aspect of the disclosure, a structure comprises: a p-well in a semiconductor substrate; a n-well in the semiconductor substrate and abutting the p-well; first diffusion regions in the n-well connecting to an anode; second diffusion regions in the p-well and connecting to a cathode; shallow trench isolation structures extending into the n-well and the p-well and isolating the first diffusion regions and the second diffusion regions; and a porous semiconductor material at junction of the n-well and the p-well.

Additional features of the structure are set forth in dependent claims 11 to 14.

In an aspect of the disclosure, a method comprises: forming a first well in a semiconductor substrate; forming a second well in the semiconductor substrate, adjacent to the first well; and forming a porous semiconductor region extending in the first well and the second well.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a silicon controlled rectifier (SCR) device with porous semiconductor material and respective fabrication processes in accordance with aspects of the present disclosure.
FIG. 2 shows an SCR device with porous semiconductor material in accordance with additional aspects of the present disclosure.
FIG. 3 shows an SCR device with porous semiconductor material of FIG. 1 and a deep N-well in accordance with aspects of the present disclosure.
FIG. 4 shows an SCR device with porous semiconductor material of FIG. 2 and a deep N-well in accordance with aspects of the present disclosure.
FIGS. 5A-5C show fabrication processes for manufacturing the SCR device with porous semiconductor material of FIG. 1 in accordance with aspects of the present disclosure.

### DETAILED DESCRIPTION

The present disclosure relates to semiconductor structures and, more particularly, to high performance silicon controlled rectifier (SCR) devices and methods of manufacture. In embodiments, the SCR devices include a porous semiconductor material, e.g., silicon, which sits on an N-well/P-well junction. Advantageously, in this configuration, the SCR devices are high holding SCR devices which also exhibit a lower trigger voltage compared to conventional SCR devices. For example, the high current performance is due to a deeper current path. Moreover, the use of porous semiconductor material effectively provides a smaller footprint compared to conventional SCR devices.

In more specific embodiments, the SCR device includes a first terminal in a first well and a second terminal in a second well adjacent to the first well. The first well abuts the second well along an interface or junction. A porous semiconductor region is provided at the junction of the first well and the second well. In this way, the interface or junction is at least partially within the porous semiconductor region. The SCR device further comprises a shallow trench isolation structure between the first terminal and the second terminal, with the porous semiconductor structure underneath the shallow trench isolation structure. In alternative embodiments, the shallow trench isolation structure may be provided within the porous semiconductor region.

The SCR devices of the present disclosure can be manufactured in a number of ways using a number of different tools. In general, though, the methodologies and tools are used to form structures with dimensions in the micrometer and nanometer scale. The methodologies, i.e., technologies, employed to manufacture the SCR devices of the present disclosure have been adopted from integrated circuit (IC) technology. For example, the structures are built on wafers and are realized in films of material patterned by photolithographic processes on the top of a wafer. In particular, the fabrication of the SCR devices uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

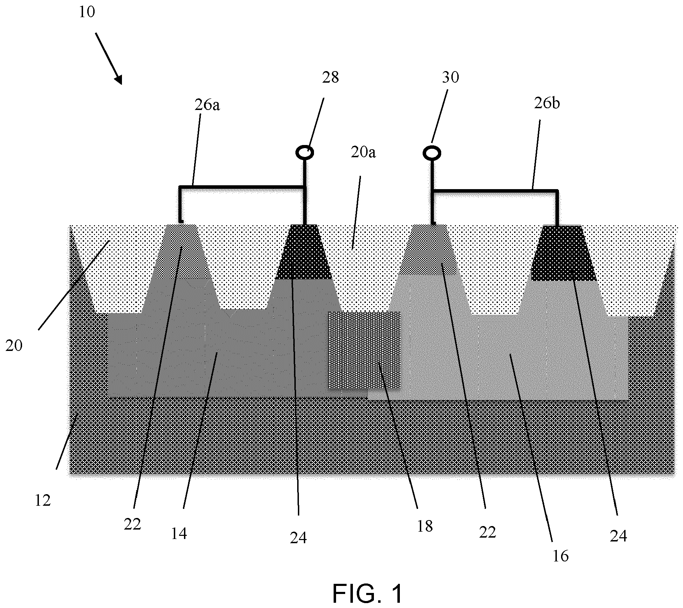

FIG. 1 shows a SCR device with porous semiconductor material and respective fabrication processes in accordance with aspects of the present disclosure. In particular, the structure 10 of FIG. 1 includes a semiconductor substrate 12 composed of any suitable material including, but not limited to, Si, SiGe, SiGeC, SiC, GaAs, InAs, InP, and other III/V or II/VI compound semiconductors. The semiconductor substrate 12 may be a lightly doped p-type semiconductor substrate. In more specific embodiments, the semiconductor substrate 12 may be a lightly doped p-type, single crystalline Si substrate with any suitable crystallographic orientation (e.g., a (100), (110), (111), or (001) crystallographic orientation).

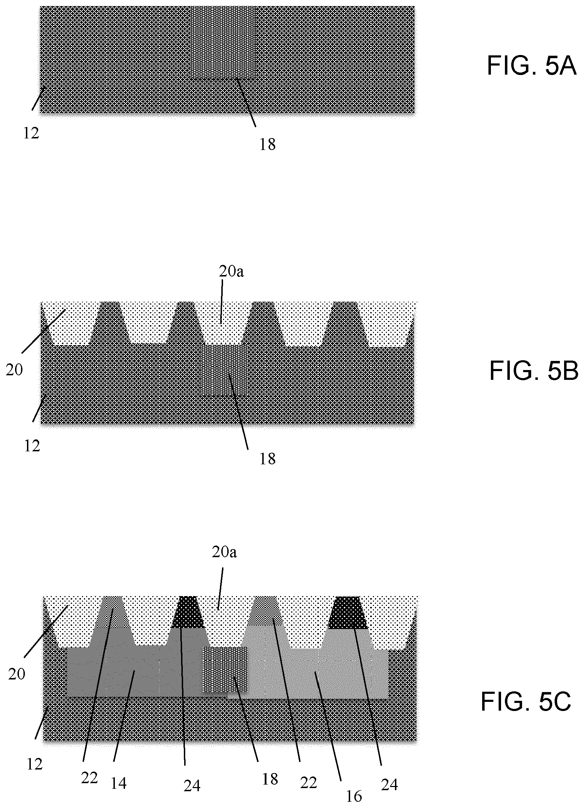

The semiconductor substrate 12 may include wells 14, 16. In embodiments, the well 14 may be an N-well and the well 16 may be a P-well. In embodiments, the wells 14, 16 are abutting. As described in more detail with respect to FIG. 5C, the wells 14, 16 may be formed by introducing different dopant types into the semiconductor substrate 12 by, for example, ion implantation processes.

A porous semiconductor material 18 may be provided at the interface or junction of the wells 14, 16. In more specific embodiments, the porous semiconductor material 18 may extend laterally into both the wells 14, 16, below a top surface of the semiconductor substrate 12. In embodiments, the porous semiconductor material 18 may be porous silicon; although other semiconductor materials are also contemplated herein. The depth of the porous semiconductor material 18 may be adjusted to different depths at the interface or junction of the wells 14, 16, depending on required device characteristics and growth processes, as examples.

In more specific embodiments, the porous semiconductor material 18 may be comprised of a porous semiconductor material having an electrical resistivity that is greater than the electrical resistivity of the semiconductor material of the semiconductor substrate 12. For example, the porous semiconductor material 18 may have an electrical resistivity that is greater than 1000 ohm-cm. In further embodiments, the porous semiconductor material 18 may have a porosity characterized by a pore size that may range from a few nanometers to several hundreds of nanometers. Moreover, in embodiments, the porous semiconductor material 18 may be free of crystalline grains and grain boundaries characteristic of a polycrystalline semiconductor material, such as polysilicon.

Still referring to FIG. 1, shallow trench isolation structures 20, 20a may be provided within the semiconductor substrate 12. In embodiments, the shallow trench isolation structures 20, 20a extend vertically into the wells 14, 16 and isolate diffusion regions 22, 24. In embodiments, the diffusion regions 22 are N+ diffusion regions and the diffusion regions 24 are P+ diffusion regions, each of which vertically extend into the semiconductor substrate 12 and, more specifically, within the wells 14, 16. In embodiments, the shallow trench isolation structure 20a is provided over and extends to the porous semiconductor material 18 at a junction of the wells 14, 16.

FIG. 1 also representatively shows contacts and/or wiring structures 26a to an anode 28 and contacts and/or wiring structures 26b to a cathode 30. In embodiments, the anode 28 is connected to the diffusion regions 22, 24 of the N-well 14 and the cathode 30 is connected to the diffusion regions 22, 24 of the P-well 16. The contacts and/or wiring structures 26a, 26b may contact silicide contacts on the diffusion regions 22, 24.

As should be understood by those of skill in the art, the silicide contacts may be formed by a silicide process which begins with deposition of a thin transition metal layer, e.g., nickel, cobalt or titanium, over fully formed and patterned semiconductor devices (e.g., doped or ion implanted diffusion regions). After deposition of the material, the structure is heated allowing the transition metal to react with exposed silicon (or other semiconductor material as described herein) in the active regions of the semiconductor device (e.g., doped or ion implanted diffusion regions) forming a low-resistance transition metal silicide. Following the reaction, any remaining transition metal is removed by chemical etching, leaving silicide contacts in the active regions of the device.

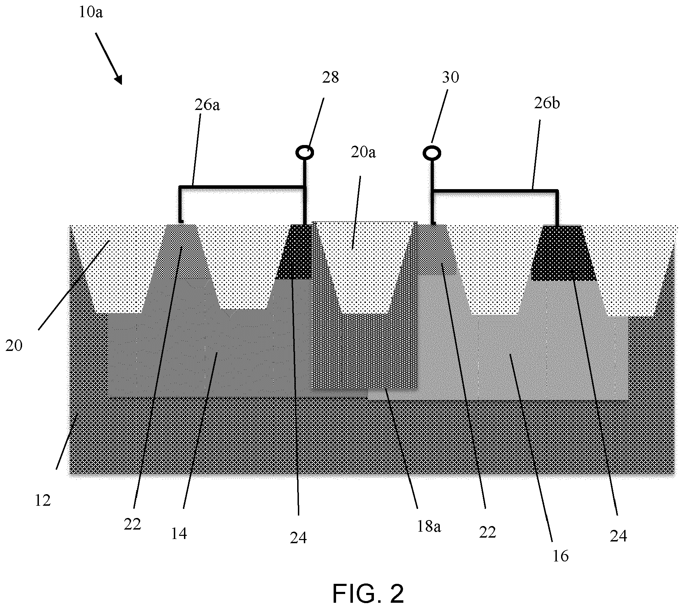

FIG. 2 shows an SCR device with porous semiconductor material in accordance with additional aspects of the present disclosure. In the structure 10a of FIG. 2, the porous semiconductor material 18a may extend to a top surface of the semiconductor substrate 12. The shallow trench isolation structure 20a may be provided within the porous semiconductor material 18a. In this way, the shallow trench isolation structure 20a is embedded within and surrounded by the porous semiconductor material 18a at a junction of the wells 14, 16. The remaining features are similar to the structure 10 of FIG. 1.

In each of the embodiments shown in FIGS. 1 and 2, the porous semiconductor material will have a lower dielectric constant than the dielectric materials of the shallow trench isolation structures 20, 20a. The porous semiconductor material will provide a higher resistance for carriers, and will exhibit a lower capacitance. The porous semiconductor material will allow the current to be pushed deeper into the semiconductor substrate 12 than conventional structures, e.g., under the shallow trench isolation structure 20a, to block current and increase the high holding voltage. Also, the use of the porous semiconductor material provides a lower trigger voltage.

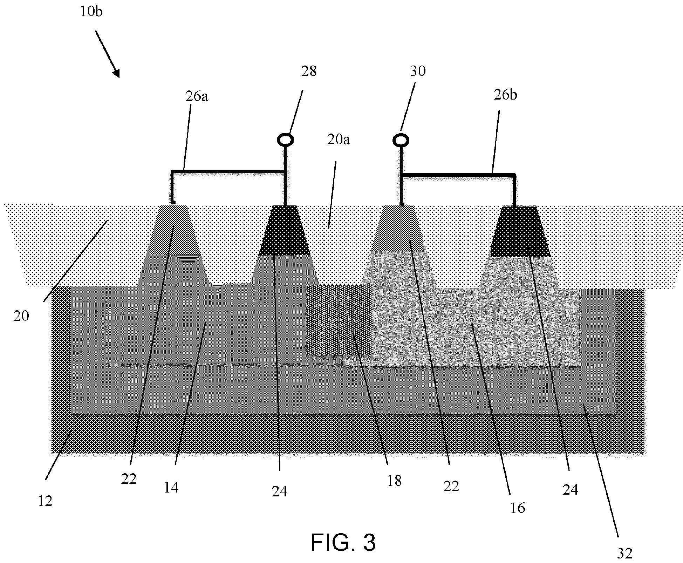

FIG. 3 shows a SCR device with porous semiconductor material of FIG. 1 and a deep N-well 32 in accordance with aspects of the present disclosure. In the structure 10b of FIG. 3, the deep N-well 32 is provided within the semiconductor substrate 12, which isolates the SCR device. In more specific embodiments, the wells 14, 16 and porous material 18 sit within the deep N-well 32 and are isolated from other devices utilizing the semiconductor substrate 12. In this way, the SCR device is isolated within the semiconductor substrate 12. The deep N-well 32 may be formed by a conventional ion implantation process as is known in the art and described herein. The remaining features of the structure 10b are similar to the structure 10 of FIG. 1.

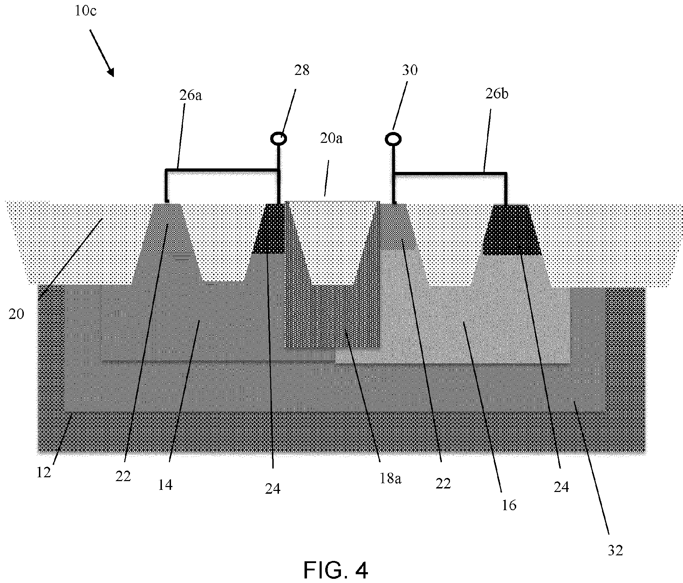

FIG. 4 shows a SCR device with porous semiconductor material of FIG. 2 and a deep N-well 32 in accordance with aspects of the present disclosure. In the structure 10b of FIG. 4, the deep N-well 32 is provided within the semiconductor substrate 12, which isolates the SCR device. In more specific embodiments, the wells 14, 16 and porous material 18 sit within the deep N-well 32 and are isolated from other devices utilizing the semiconductor substrate 12. In this way, the SCR device is isolated within the semiconductor substrate 12. The deep N-well 32 may be formed by a conventional ion implantation process as is known in the art and described herein. The remaining features of the structure 10b are similar to the structure 10a of FIG. 2.

FIGS. 5A-5C show fabrication processes for manufacturing the SCR device with porous semiconductor material of FIG. 1. In FIG. 5A, for example, the porous semiconductor material 18 is formed within the semiconductor substrate 12. In embodiments, the porous semiconductor material 18 may be fabricated by, for example, electrochemical anodization or chemical etching of single-crystal semiconductor material of the semiconductor substrate 12. The porous semiconductor material 18, amongst the features noted with respect to FIG. 1, includes a single-crystal matrix and interconnected pores distributed within the single-crystal matrix.

In FIG. 5B, shallow trench isolation structures 20, 20a are formed within the semiconductor substrate 12. The shallow trench isolation structures 20, 20a may be positioned to extend within wells 14, 16 and isolate diffusion regions 22, 24 which are formed in later fabrication processes as shown in FIG. 5C. The shallow trench isolation structures 20, 20a can be formed by conventional lithography, etching and deposition methods known to those of skill in the art.

For example, a resist formed over the semiconductor substrate 12 and porous semiconductor material 18 is exposed to energy (light) and developed to form a pattern (opening). An etching process with a selective chemistry, e.g., reactive ion etching (RIE), will be used to transfer the pattern from the patterned photoresist layer to the semiconductor substrate 12. In embodiments, the etching process to form the trench for the shallow trench isolation structure 20a may completely remove the porous semiconductor material 18 at the upper portion of the structure. In the alternative embodiment shown in FIG. 2, the etching process to form the trench for the shallow trench isolation structure 20a will partially remove the porous semiconductor material 18. In either configuration, following the resist removal by a conventional oxygen ashing process or other known stripants, insulator material (e.g., SiO₂) can be deposited by any conventional deposition processes, e.g., chemical vapor deposition (CVD) processes within the respective trenches. Any residual material on the surface of the semiconductor material 12 can be removed by conventional chemical mechanical polishing (CMP) processes.

FIG. 5C shows the fabrication processes of forming the wells 14, 16 and diffusion regions 22, 24. The wells 14, 16 and diffusion regions 22, 24 may be formed by introducing a concentration of a different dopant of opposite conductivity type in the semiconductor substrate. The wells 14, 16 will abut one another; whereas the diffusion regions 22, 24 will be provided between the shallow trench isolation structures 20, 20a and within the wells 14, 16.

In embodiments, respective patterned implantation masks may be used to define selected areas exposed for the implantations of the wells 14, 16 and diffusion regions 22, 24. The implantation mask used to select the exposed area for forming a well and/or fission regions is stripped after implantation, and before the implantation mask used to form another well or diffusion regions of different conductivity type. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The P-well 16 and p-diffusion regions 24 may be doped with different concentrations of p-type dopants, e.g., Boron (B), and the N-well 14 and n-diffusion regions 22 may be doped with different concentrations of n-type dopants, e.g., Arsenic (As), Phosphorus (P) and Antimony (Sb), among other suitable examples. An annealing process may be performed to drive in the dopant into the semiconductor substrate 12.

Referring back to FIG. 1, the contacts and/or wiring structures 26a, 26b may be formed by conventional back end of the line (BEOL) processes. For example, an interlevel dielectric material may be deposited over the semiconductor substrate 12, which is then subjected to lithography and etching processes (e.g., RIE), followed by deposition of metal or metal alloy material, e.g., tungsten with a TaN or TiN liner. Any residual metal or metal alloy material on the interlevel dielectric material may be removed by a conventional chemical mechanical polishing (CMP) process.

As should be understood by those of skill in the art, the silicide process begins with deposition of a thin transition metal layer, e.g., nickel, cobalt or titanium, over fully formed and patterned semiconductor devices (e.g., doped or ion implanted diffusion regions). After deposition of the material, the structure is heated allowing the transition metal to react with exposed silicon (or other semiconductor material as described herein) in the active regions of the semiconductor device (e.g., doped or ion implanted diffusion regions) forming a low-resistance transition metal silicide. Following the reaction, any remaining transition metal is removed by chemical etching, leaving silicide contacts in the active regions of the device.

The SCR devices can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a first well in a semiconductor substrate;
a second well in the semiconductor substrate, adjacent to the first well; and
a porous semiconductor material extending in the first well and the second well.

2. The structure of claim 1, wherein the porous semiconductor material is at an interface of the first well which abuts the second well.

3. The structure of claim 1 or claim 2, further comprising a deep N-well within the semiconductor substrate, wherein the first well, the second well and the porous semiconductor material sit within the deep N-well such that the structure is isolated in the semiconductor material.

4. The structure of one of claims 1 to 3, wherein the first well comprises an N-well and the second well comprises a P-well.

5. The structure of one of claims 2 to 4, further comprising at least one shallow trench isolation structure at the interface of the first well and the second well.

6. The structure of claim 5, wherein the porous semiconductor material is under the at least one shallow trench isolation structure, or wherein the at least one shallow trench isolation structure is within the porous semiconductor material.

7. The structure of claim 5, wherein the at least one shallow trench isolation structure comprises plural shallow trench isolation structures extending into the first well and the second well, and isolating diffusion regions connecting to an anode and to a cathode.

8. The structure of one of claims 1 to 7, wherein the porous semiconductor material comprises porous silicon, and/or wherein the porous semiconductor material is free of crystalline grains and grain boundaries characteristic of a polycrystalline semiconductor material.

9. The structure of one of claims 1 to 8, wherein the porous semiconductor material comprises an electrical resistivity greater than an electrical resistivity of the semiconductor substrate, and, optionally, wherein the porous semiconductor material comprises an electrical resistivity greater than 1000 ohm-cm.

10. A structure comprising:
a p-well in a semiconductor substrate;
an n-well in the semiconductor substrate and abutting the p-well;
first diffusion regions in the n-well connecting to an anode;
second diffusion regions in the p-well and connecting to a cathode;
shallow trench isolation structures extending into the n-well and the p-well and isolating the first diffusion regions and the second diffusion regions; and
a porous semiconductor material at junction of the n-well and the p-well.

11. The structure of claim 10, wherein the porous semiconductor material is under a shallow trench isolation structure at the junction of the n-well and the p-well.

12. The structure of claim 10 or claim 11, wherein a shallow trench isolation structure at the junction of the n-well and the p-well is within the porous semiconductor material.

13. The structure of one of claims 10 to 12, wherein the porous semiconductor material comprises porous silicon, and/or wherein the porous semiconductor material is free of crystalline grains and grain boundaries characteristic of a polycrystalline semiconductor material.

14. The structure of one of claims 10 to 13, wherein the porous semiconductor material comprises an electrical resistivity greater than an electrical resistivity of the semiconductor substrate, and, optionally, wherein the porous semiconductor material comprises an electrical resistivity greater than 1000 ohm-cm.

15. A method comprising:
forming a first well in a semiconductor substrate;
forming a second well in the semiconductor substrate, adjacent to the first well; and
forming a porous semiconductor material extending in the first well and the second well.
